# EUROPEAN PATENT APPLICATION

(11) **EP 2 166 670 A1**
(43) Date of publication of application: **24.03.2010**
(21) Application number: 08290896.3
(22) Date of filing: 23.09.2008
(51) Int. Cl.: H03K 17/96, H01H 13/7073

(54) **Capacitive sensor and relative method of production**

(71) Applicant: Invensys Controls Europe, 74160 Archamps (FR)
(72) Inventor: Ramos, Joël, 74250 Fillinges (FR); Pasquier, Patrick, 74300 Cluses (FR)
(74) Representative: Ligi, Stefano

(57) **Abstract**

Capacitive sensor for a touch-type control board for electronic apparatuses, comprising at a first end a base portion (30) suitable to be connected electrically to a predetermined conductive area of said electronic board (20), and at a second end, opposite the first end, a sensing portion (34), able to be associated with a predetermined sensitive area (16) of the control board, **characterized in that** said capacitive sensor comprises two metal foils (32a, 32b), elastic and flexible, attached at one side to said base portion (30) and at the other side to said sensitive portion (34), said foils (32a, 32b) having a segmented conformation in at least two consecutive segments having opposite directions, said foils (32a, 32b) being adjacent to each other and substantially mounted specular with respect to each other, so as to be able to be deformed in a substantially independent manner one with respect to the other, in several different directions, to make adhere elastically the sensitive portion (34) to the sensitive area (16) and to avoid any air gap.

## Description

### FIELD OF THE INVENTION

The present invention concerns a capacitive sensor, and the relative production method, used preferably but not only in order to make control boards of the touch type for electronic apparatuses such as household appliances, televisions, audio/video players, radios or other.

### BACKGROUND OF THE INVENTION

It is known to use touch type control boards for electronic apparatuses, which comprise a front panel made of insulating material, such as plastic, ceramic, glass or other. The front panel has an external surface suitable to be touched by a user in correspondence with one or more sensitive areas. Each sensitive area corresponds to a command or to a sequence of predefined commands.

In this field it is known, and becoming ever more widespread, to use capacitive sensors, made of conductive material, and generally consisting of a flexible and elastic element, for example a spring or metal foil. The flexible element has a first end coupled mechanically with an internal surface of the front panel, in correspondence with an associated sensitive area, and a second end connected both mechanically and electrically to an electronic card, or printed circuit board (PCB).

The variation in capacity of capacitive sensors determined by approach and/or contact by the user in correspondence with the sensitive area, and the consequent capacitive field variation, determines the desired command, transmitted to the apparatus through the circuits on the electronic card.

The flexibility and elasticity of the capacitive sensor facilitate the mechanical coupling of front panel and the electronic card, allowing to maintain their disposition with respect to the sensitive areas stable over time. This facilitates both the design of the board and also its assembly in the electronic apparatus.

The sensitive areas can also be associated with lighting elements such as LEDs or other, mounted on the electronic card, and able to illuminate the sensitive area from the rear, so as to identify it better or to provide functional and/or diagnostic indications to the user while the apparatus is functioning. The LEDs can be associated with light diffusers or light guides, suitable to transfer the beam of light emitted toward the corresponding sensitive area of the front panel, to render the lighting more effective and uniform.

One disadvantage of capacitive sensors such as these is that, in order to maintain an effective mechanical coupling both with the front panel and also with the electronic card, it is not always possible to dispose the latter efficiently so as to reduce bulk and/or to facilitate the assembly of the control board. In the state of the art this entails the need to keep the plate and the electronic card as much as possible substantially parallel.

Another disadvantage is that known capacitive sensors are assembled, during the production of the electronic card, in the step when associated electronic components are assembled. This entails an increase in the production costs, a risk of defects and errors in assembly, and also an increase in the bulk of the cards themselves for temporary storage, before their definitive assembly in the electronic apparatuses.

Another disadvantage of known capacitive sensors is that they do not allow to easily make an electric coupling any PCB conductive face of an electronic card in case one copper face or of the double copper layer type.

Another disadvantage is that the association of the LEDs and the corresponding light diffusers with each capacitive sensor, and hence with each sensitive area, is rather complicated. This entails both an inefficient topological distribution of the conductive pathways feeding the LEDs on the electronic card, and also the need to use auxiliary support elements for the light diffusers.

One purpose of the present invention is to achieve a capacitive sensor for a touch type control board which can be coupled efficiently both with a front panel of the control board and also with a copper face of an electronic control card, according to a desired reciprocal disposition, also with the front panel that is not parallel to the electronic card, and also with considerable and variable distances between the front panel and the electronic card.

Another purpose is to achieve a capacitive sensor which can be easily mounted on the electronic card even at a later stage than during the production of the card and the assembly of its components.

Another purpose is to achieve a capacitive sensor for a touch type control board that can be associated effectively both with a light element, also disposed in the center of a sensitive area in the front panel, and also with light guide elements without requiring additional and complex mechanical support devices.

Another purpose is to achieve a capacitive sensor for a touch type control board which has a wide usable surface in proportion to the contact area of the plate.

Another purpose is to perfect a method to make a capacitive sensor for a touch type control board which allows to reduce the production times and costs thereof.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In accordance with the above purposes, a capacitive sensor according to the present invention is used to make a capacitive touch type control board for electronic apparatuses such as household appliances, television, audio/video players, radios or other.

The capacitive sensor, made of electrically conductive material, comprises at one end a substantially plane base portion suitable to be connected electrically to a predetermined conductive area of an electronic board. The electronic board is disposed inside the electronic apparatus in a pre-determined position, separate or distanced with respect to the control board. The capacitive sensor also comprises, at a second end, opposite the first end, a sensing portion, also substantially plane, able to be associated with a predetermined flat sensitive area of the control board.

According to the present invention, the capacitive sensor consists of at least two metal foils, elastic and flexible, having a segmented conformation in at least two consecutive segments having opposite directions. The foils are adjacent to each other and substantially mounted specular with respect to each other, so that they can be deformed in a substantially independent manner in different directions in order to make adhere elastically the sensing portion of the capacitive sensor to the sensitive area of the control board and to avoid any air gap. In this way, less air gap allows better sensitive answer when a user approaches or touches the sensitive area of the control board.

In a preferential embodiment, the two foils are connected to each other at least in correspondence with the base portion anchored to the electronic board.

In another preferential embodiment, at least in correspondence with the base portion a hole is made, for housing a light element, such as a LED or suchlike, and/or a light diffuser, which emits or transports the light substantially in correspondence with the sensitive area of the control board.

According to a variant of the invention, the base portion can be associated with the electronic board by means of mechanical coupling that also achieves the corresponding electric connection with said conductive area. In this way it is possible to attach the capacitive sensor to the electronic board without welding or attachment operations with glues or conductive pastes.

According to the present invention the two foils, initially plane, are shaped in the form of an M.

According to a variant, the two foils are first made by shearing, at the same time making the base portion from which the foils branch off, in different directions and on two parallel but distanced directrixes.

According to another variant, in obtaining the two foils in a single piece with the base portion, said hole is also obtained.

According to another variant, apart from the hole, two tongues are also obtained in the base portion, in opposite sides of two foils.

According to another variant, in the zones of the two metal foils where the V shape of the M is formed, and at the free point of the M, corresponding to the sensing portion, in a position that will be specular, removals are obtained that will form a channel for the light to transit and for positioning.

Another variant is to obtain, in correspondence with each removal made in the V shape of the M, a reinforcement edge able to not allow the flexion of the foils in each segment of their V shape and at the same time to constitute a container for the light.

Another variant is to achieve a bridge type deformation in the base portion, with the axis of deformation advantageously orthogonal to the extension of the foils.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a schematic view of a capacitive sensor according to the present invention associated with a front panel and an electronic board;
- fig. 2 is an exploded view of the capacitive sensor and the electronic board;
- fig. 3 is an upside-down three-dimensional view of the capacitive sensor in fig. 1 mounted on the electronic board;
- fig. 3A is an enlarged view of a detail of fig. 3;
- fig. 4 is a three-dimensional view of a variant of fig. 2;
- fig. 4A is an upside-down three-dimensional view of fig. 4 in a different circuit configuration;
- fig. 4B is a three-dimensional view from above of fig. 4A;
- fig. 5 is an enlarged section view from V to V in fig. 4;
- fig. 6 is a three-dimensional view of the capacitive sensor according to the present invention, associated with a light diffusion device;
- fig. 7 is a schematic view of a step of production of the capacitive sensor according to the present invention;
- fig. 8 is a three-dimensional view of the capacitive sensor associated with a second light diffusion device.

### DETAILED DESCRIPTION OF A PREFERENTIAL FORM OF EMBODIMENT

With reference to the attached drawings, a capacitive sensor 10 according to the present invention is used in a touch type control board of one or more electronic apparatuses, for example a household appliance like a washing machine, a kitchen hood, a dishwasher or other, also connected to each other by means of a common command system and smart management.

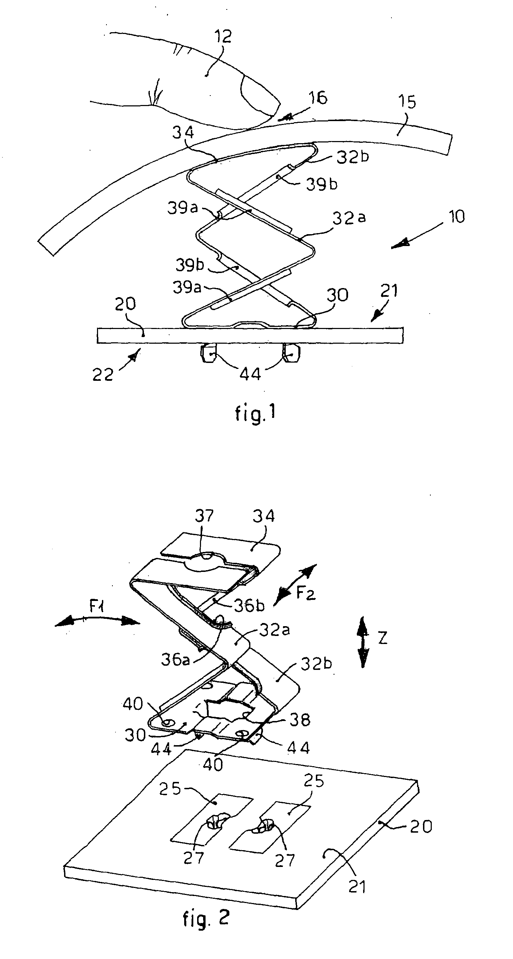

Fig. 1 shows a portion of a front panel 15 of the control board; the front panel 15 is made of insulating material, and has a sensitive area 16, generally identified by printing, in correspondence with which a user can touch or approach his finger 12 in order to execute commands, to set up a program, request information or other.

The front panel 15 in this case has a curvilinear shape and can be associated with a plurality of capacitive sensors 10, each suitable to execute a specific function or command.

The capacitive sensor 10 is mechanically associated on one side with a portion of the front panel 15 in correspondence with said sensitive area 16 and, on the opposite side, anchored and electrically connected to an electronic card 20, to manage the functions and commands imparted by the user by means of the front panel 15. The electronic card 20 may comprise, in a known manner, electronic components such as resistances, inductors, capacities, transistors, integrated circuits and/or microprocessors/microcontrollers, according to a topological pattern generated on an associated electric layout defined during the design stage, and not shown in detail here since they are not relevant for understanding the invention.

The capacitive sensor 10 is made of electrically conductive and flexible material, such as for example brass, bronze, stainless steel or other, and comprises a base 30, anchored to the card electronic 20, and a pair of foils 32a and 32b consisting of consecutive segments oriented in opposite directions, in order to guarantee the flexibility and partial deformability thereof.

The two foils 32a and 32b are disposed substantially specularly opposite each other.

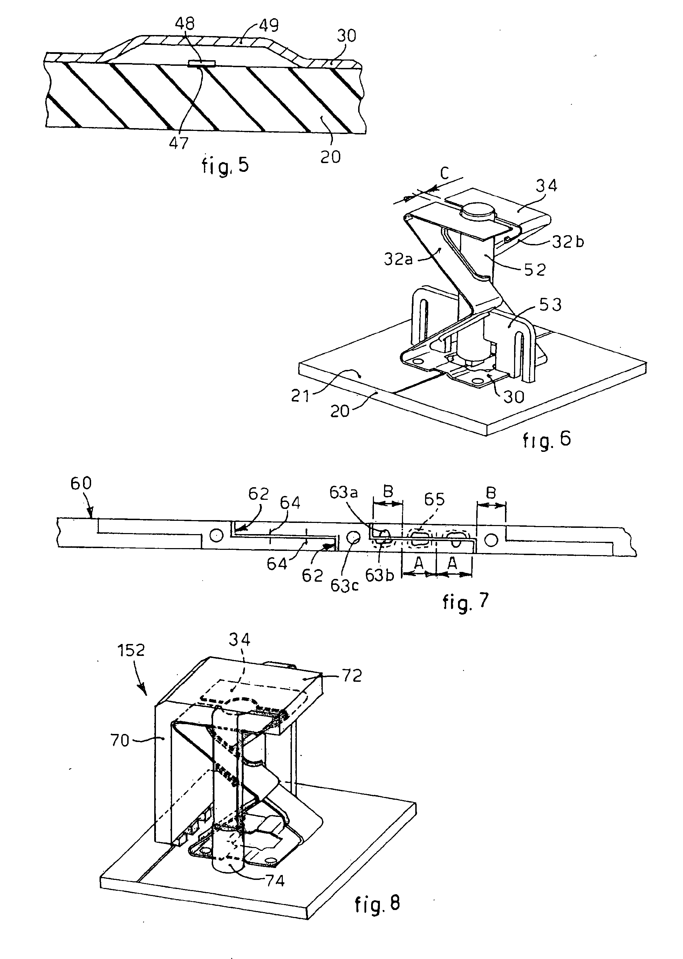

The terminal part of the sensor 10, on the opposite side of the base 30, is substantially plane and defines a pair of blades 34, in this case in a single piece with said foils 32a, 32b, associated with the internal face of the contact plate 15 in correspondence with the sensitive area 16. The base 30, each foil 32a, 32b and each blade 34 are reciprocally disposed in an M-shape. The central portion of the M, that is, the V-shaped part, is substantially formed by each foil 32a, 32b. The blades 34 are also disposed (fig. 6) so as to be slightly distanced by a gap "c". The foils 32a, 32b are also disposed separated from each other so as to create between them a space that facilitates their deformation and prevents interference, ensuring optimum flexibility.

The base 30, in this case, has a square shape and substantially plane, suitable to be connected electrically to one or more pads 25, made of copper or other electrically conductive material, made in the upper face 21 of the electronic card 20. Fig. 2 shows two pads 25 of a substantially rectangular shape, disposed parallel and such as to allow a surface electric coupling with a lower portion of the base 30.

The base 30 also comprises a hole 38, disposed substantially central, in correspondence with which two tongues 44 are made, by shearing and subsequent bending downward. The tongues 44 are substantially orthogonal to the base 30, and serve to attach the capacitive sensor 10 to the electronic card 20.

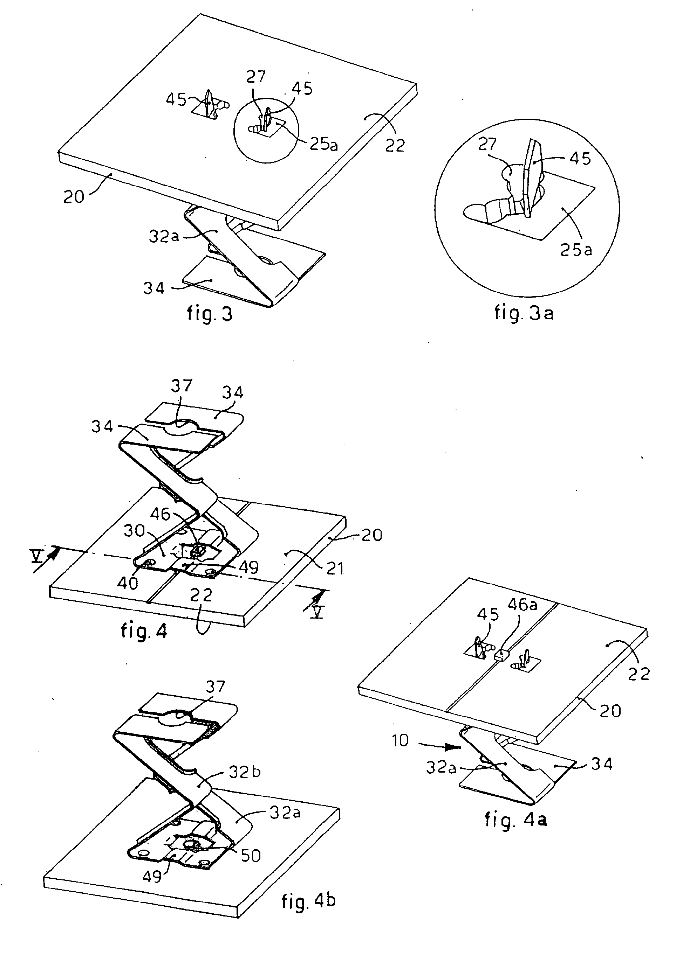

Each tongue 44 is suitable to cooperate with mating attachment holes 27 made in proximity with the conductive pads 25. Furthermore, each tongue 44 comprises a substantially L-shaped portion 45 (fig. 3A), suitable to cooperate with the lower face 22 of the electronic card 20 so as to ensure a stable and safe coupling of the base 30. The L-shaped portions 45 also allow to obtain a precise and stable positioning of the capacitive sensor 10 on the electronic card 20.

Thanks to this configuration, the capacitive sensor 10 is easily mounted on the electronic card 20 by means of mechanical coupling, which also guarantees a continuity of electric connection between the base 30, that is between the capacitive sensor 10 and the conductive pads 25 and 25 a.

The sensor 10 can therefore be mounted even during a step subsequent to the assembly of electronic components, and is normally stabilized by mechanic means also after the assembly of other components on the electronic card 20. Welding or attachment with adhesive pastes of a conductive type can be also done. This allows to use welding ovens for the less voluminous and therefore more efficient electronic components, and also to optimize the packing of each electronic card 20 before its final assembly.

Moreover, in the case of an electronic board in which the electronic components are of the SMD type, the mounting of the sensor 10 in a successive step than that of the mounting of the SMD components, avoids to expose the sensor 10 to high temperatures (around 270 °C) of a refusing oven. In this way, flexibility behavior of the sensor is not affected by the refusing temperatures.

Furthermore, this allows to simplify and accelerate the functional tests and inspections of the finished electronic cards 20. In fact, the tests and inspections relating to the functionality of the capacitive sensor 10 include the electric testing of the pads 25, since the corresponding electric continuity of the sensor 10 is guaranteed by virtue of its mechanical attachment and anchorage.

The L-shaped portions 45 of the tongues 44 also allow to achieve an electric coupling with a corresponding pad 25a disposed on the lower face of the electronic card 20 (figs. 3 and 3A). This allows greater flexibility both in design and in production, allowing to integrate the sensor 10 in electronic cards 20 of single copper layer type (copper disposed on the same or on the opposite sensor side) or of double copper layer type, therefore, given the same sizes, with a larger number of electronic components.

The base 30 also comprises, substantially at the four corners, spherical or semispherical contacts 40, made for example through deformation of material. The contacts 40 are made so as to protrude with respect to the lower face 22 of the base 30, to render more effective the continuity of the electric connection between the base 30 and each conductive pads 25.

The segmented foils 32a, 32b are suitable to create a flexible and elastically deformable mechanical connection between the base 30, solid with the electronic card 20, and the plane blades 34, connected to the front panel 15 in correspondence with the sensitive area 16.

In particular, the configuration with two flexible foils 32a, 32b, substantially V-shaped, adjacent and opposite each other substantially specularly, in which the foils 32a, 32b develop in a direction substantially orthogonal to the plane of the electronic card 20, determines a deformability of the capacitive sensor 10 in at least three directions. This increases the sensing sensitivity thanks to the greater contact surface, and also the stable positioning and elastic return.

In particular, the deformation of the sensor 10, following the positioning of the electronic card 20 with respect to the front panel 15, can take place in a substantially longitudinal direction (fig. 2), as indicated by the arrow Z, or according to two possible rotations of each of the conductive foils 32a, 32b, according to the arrows F1 (torsional rotation) and F2 (rotation through flexion with respect to the base 30). This deformation of the two foils 32a, 32b therefore allows an always efficient disposition of the sensing blades 34 with respect to the corresponding sensitive area 16 of the front panel 15, so as to keep said blades 34 always the maximum contact area and the minimum air gap with a lower portion of the front panel 15 in order to correctly sense the corresponding capacitive variation.

This allows to adapt the disposition of the sensing blades 34 according to the reciprocal disposition in use of the electronic card 20 and the front panel 15, and also the shape of the front panel 15 itself, also curvilinear and therefore not parallel to the electronic card 20.

In the solution shown in figs. 2, 4, 5 and 6, the capacitive sensor 10 comprises a seating, in this case a hole 38 made centrally in the base 30, suitable for coupling with one or more light emission elements, such as LEDs 46, 46 a, and/or associated light diffusers, such as a light guide, in order to illuminate the respective sensitive area 16 from the rear. The hole 38 allows to mount LED 46 on the upper face 21 of the plate in case using PCB single copper layer opposite to the side on which the sensor is mounted.

The light of the LED 46 can be transmitted through the capacitive sensor 10 and toward the contact plate 15 also thanks to the disposition of the foils 32a, 32b, reciprocally opposite and slightly distanced by the gap "c", and to an emission hole 37 made centrally on the blades 34.

Each segment of the foils 32a, 32b has recesses 36a, 36b, elongated in shape, disposed toward the inside of each foil 32a, 32b, and able to cooperate both reciprocally and with a recess on the other foil, and also with the hole 37 so as to achieve a transit channel for the light emitted by the LED 46 and/or for the positioning and stable assembly of a substantially cylindrical light guide 52 which couples below with the LED 46 and transmits the light to the contact plate 15 in correspondence with the sensitive area 16.

Each recess 36a, 36b is also associated with a reinforcement strip 39a, 39b, made on the perimeter of the recess, and suitable to prevent the flexion of each segment of the foils 32a, 32b. In this way the deformation in a longitudinal direction of the sensor 10 takes place substantially in correspondence with the tops of the M-shapes of the sensor 10. The reinforcement strips 39a, 39b also constitute a support and passage seating for the light guide 52.

In the embodiment shown, the light guide 52 also comprises support fins 53 suitable to cooperate with the electronic card 20 in order to keep the light guide 52 associated stably with the capacitive sensor 10. The elasticity of the foils 32a, 32b and of the blades 34, together with the separation gap "c", allows easy insertion of the light guide 52 and its support fins 53.

In this way a light guide 52 associated with the capacitive sensor 10 can be assembled without additional support elements and hence can be assembled quickly, allowing to reduce the times and costs of production.

In an alternative assembly solution, shown in fig. 8, a second light diffuser 152 (fig. 8) is associated with the capacitive sensor 10, having a vertical portion 70, assembled adjacent to the sensor 10 and suitable to diffuse vertically the light emitted by one or more LEDs 46 disposed on the electronic card 20 outside the dimensional bulk of the base 30. The second light diffuser 152 also comprises a horizontal portion 72, in proximity with the sensitive area 16, and suitable to diffuse horizontally the light transmitted through the vertical portion 70, under the sensitive area 16.

The horizontal portion 72 can be associated with an element in which a graphical element is impressed, so as to illuminate the corresponding sensitive area 16 from the rear, and highlight it luminously for example by means of a symbol or an icon, a writing or other. The light diffuser 152 also comprises support columns 74 suitable to attach it to the electronic card 20, keeping the vertical portion 70 slightly raised with respect to the LED 46.

According to another variant shown in figs. 4 and 5, the base 30 of the capacitive sensor 10 comprises a bridge element 49, made by deformation of a corresponding portion of the base 30 and at least partly raised with respect thereto. The bridge element 49 allows a conductive pathway 47 to pass under the base 30, preventing any electric contact. With reference to fig. 5, in fact, which shows the bridge element in fig. 4 in enlarged section, the pathway 47 is associated with its protective layer, that is, the solder mask 48, and is physically and electrically separated from the base 30.

In this way it is possible to achieve directly on the upper face 21 of the electronic card 20 a feed pathway 48 passing under the base 30 to feed the LED 46, avoiding the need to have double copper PCB faces and using metalized holes to pass from side 22 to 21. This increases the planning flexibility of the circuit disposition of the electronic components, allowing a substantial reduction in the sizes and cost of the electronic card 20.

It is also possible to mount the LED 46a on the lower face 22 of the electronic card 20, when the only useable face or conductive layer is the one opposite the face where the capacitive sensor is mounted. In fact (figs. 4A, 4B), on the electronic card 20, in correspondence with the assembly seating of the LED 46a, a second through hole 50 is provided, which allows to transmit the light emitted toward the opposite face and therefore through the hole 38, toward the sensitive area 16.

The capacitive sensor 10 according to the present invention is assembled as follows.

The sensor 10 is disposed with its base 30 in correspondence with a predefined area of the electronic card 20 comprising the conductive pads 25, 25a, making the base 30 adhere to the surface of the first face 21 and inserting the tongues 44 into the attachment holes 27. The L-shaped portions 45 of the tongues 44 are then bent through rotation (fig. 3A) in the direction of the arrow F so as to cooperate with the second face 22 and ensure the mechanical clamping of the sensor 10 to the electronic card 20. This clamping exerts a tightening action so as to allow the adhesion of the base 30, that is, of the contacts 40, with the conductive pads 25, at the same time ensuring a stable electric contact. The electronic card 20 is then attached or disposed in correspondence with the command board 14, under the front panel 15, coupling each capacitive sensor 10 with an associated sensitive area 16. This disposition occurs in such a manner as to dispose the sensing blade or blades 34 effectively, for example in contact, with the front panel 15.

A possible method to achieve the capacitive sensor 10 as described heretofore may comprise the following steps (fig. 7).

In a first step, a plane foil 60 is made, of flexible conductive material, with a width equal to the width of the capacitive sensor 10 in its final form.

In a second step, first cutting lines 62 are made in the foil 60, suitable to define the subsequent cutting of the foil 60 into the plane shape of the capacitive sensor 10, in which the separation gap "c" between the blades and the foils 32a, 32b is also defined. By plane shape we mean the surface development on one plane of the capacitive sensor 10. In this step bending lines 64 are also made, which subsequently allow to define a portion corresponding to the base 30, and portions corresponding to the foil or foils 32a, 32b and to the blades 34.

In the second step second cutting lines 63a, 63b, 63c are also defined, which define lines for removing metal material. The cutting lines 63a, 63b, 63c are obtained, respectively, with a semi-circular shape to make the emission hole 37, with a semi-rectangular shape to make the recess 36, and with a partly circular shape to make the hole 38 comprising a portion, not shown in the drawings, to define the tongues 44. In this step a second bending line 65 is also defined, for example a dotted line suitable to make reinforcements 39a, 39b in the segmented foils 32a, 32b.

The method also comprises a step in which the foil 60 is first cut according to said cutting lines 62, also removing the material in correspondence with the cutting lines 63a, 63b, 63c. The foil is then bent according to said bending lines 64 and 65, so as to dispose the base 30 and the blades 34 in a substantially parallel reciprocal position, and the foils 32a, 32b in a segmented disposition in consecutive segments which develops orthogonally with respect to the base 30.

The base 30, the segmented foils 32a, 32b and the plane blades 34 are disposed in a substantially M-shaped form.

The base 30 is also partly deformed so as to achieve the bridge element 49 in which the axis of the deformation is substantially orthogonal to the extension of the segmented foils 32a, 32b.

This solution allows to considerably reduce any waste in working the material.

It is clear that above mentioned steps may not be executed in the exact order with which they have been described, as well as it is clear that a person of skill in the art shall certainly be able to achieve many other equivalent methods to achieve the capacitive sensor 10 as described heretofore.

It is clear that modifications and/or additions of parts and/or steps may be made to the capacitive sensor 10 and the relative production method as described heretofore, without departing from the field and scope of the present invention.

It is also clear that, although the present invention has been described with reference to some specific examples, a person of skill in the art shall certainly be able to achieve many other equivalent forms of capacitive sensor and relative production method, having the characteristics as set forth in the claims and hence all coming within the field of protection defined thereby.

## Claims

1. Capacitive sensor, used to make a touch type control board for electronic apparatuses, wherein the control board comprises at least a sensitive area (16), said sensor comprising at a first end a base portion (30) suitable to be connected electrically to a predetermined conductive area of an electronic board (20), and at a second end, opposite the first end, a sensing portion (34), able to be associated with said predetermined sensitive area (16), **characterized in that** said capacitive sensor comprises at least two metal foils (32a, 32b), elastic and flexible, attached at one side to said base portion (30) and at the other side to said sensitive portion (34), said foils (32a, 32b) having a segmented conformation in at least two consecutive segments having opposite directions, said foils (32a, 32b) being adjacent to each other and substantially mounted specular with respect to each other, so as to be able to be deformed in a substantially independent manner one with respect to the other, in several different directions, to make adhere elastically the sensitive portion (34) to the sensitive area (16) and to avoid any air gap.

2. Capacitive sensor as in claim 1, **characterized in that** said two foils (32a, 32b) extend substantially orthogonally to the plane defined by said electronic board (20) and are connected to each other at least in correspondence with the base portion (30) anchored to the electronic board (20).

3. Capacitive sensor as in any claim hereinbefore, **characterized in that** it comprises, on the opposite side of said base portion (30), a pair of blades (34) defining said substantially plane contact portion with the internal face of the control board in correspondence with said sensitive area (16).

4. Capacitive sensor as in any claim hereinbefore, **characterized in that** said base portion (30) comprises tongues (44) to attach the sensor to said electronic board (20).

5. Capacitive sensor as in claim 4, wherein said electronic card (20) comprises conductive pads (25, 25a) at least on one face (21, 22) thereof, **characterized in that** each tongue (44) can be associated, in order to assemble said electronic board (20), with mating attachment holes (27) made in proximity with said conductive pads (25, 25a).

6. Capacitive sensor as in any claim from 3 to 5, **characterized in that** said blades (34) together with said foils (32a, 32b) are M-shaped.

7. Capacitive sensor as in any claim hereinbefore, **characterized in that** said base portion (30) comprises contacts (40) disposed protruding below said base portion (30) and able to improve the electric connection between the base portion (30) and each conductive pads (25).

8. Capacitive sensor as in any claim hereinbefore, **characterized in that** at least in correspondence with the base portion (30) a hole (38) is made for housing a light element (46), and/or a light diffuser, which emits or transports the light in substantial correspondence with the sensitive area (16) of said control board.

9. Capacitive sensor as in claim 8, **characterized in that** said blades (34) define, in a substantially central position, an emission hole (37) through which the light generated by the light element (46) can be transmitted.

10. Capacitive sensor as in claim 9, **characterized in that** it comprises a light guide element (52) associated below said light element (46) and housed at least partly in said hole (38) of the base portion (30) and in said emission hole (37) made between said blades (34).

11. Capacitive sensor as in any claim from 8 to 10, **characterized in that** said foils (32a, 32b) comprise recesses (36a, 36b) to define a passage way for the light from the base portion (30) toward the sensitive area (16) of said control board.

12. Capacitive sensor as in claim 11, **characterized in that** said recesses (36a, 36b) comprise a reinforcement edge (39a, 39b) able to prevent the flexion of the foils (32a, 32b) in each of said segments.

13. Capacitive sensor as in any claim hereinbefore, **characterized in that** said base portion (30) comprises a bridge type deformation (49) orthogonal to the extension of said foils (32a, 32b).

14. Method to make a capacitive sensor as in any claim hereinbefore, **characterized in that** it comprises:
- a step in which a plane foil (60) is made, of flexible conductive material, with a width coherent with the width of the capacitive sensor (10) in its final form;
- a step in which cutting lines (62) are made in the foil (60), suitable to define the subsequent cutting of the foil (60) according to the plane surface development of the capacitive sensor (10);
- a step in which bending lines (64) are made, which allow to define a portion corresponding to the base portion (30), and portions corresponding to the segmented foils (32a, 32b) and to the contact portion (34);
- a step in which the foil (60) is first cut according to said cutting lines (62), and then bent according to said bending lines (64), so as to dispose the base portion (30) and the contact portion (34) in a substantially parallel reciprocal position, and the segmented foils (32a, 32b) in a segmented disposition in consecutive segments which develops orthogonally with respect to the base portion (30).

15. Method as in claim 14, **characterized in that** said contact portion comprises blades (34) which together with said foils (32a, 32b) are M-shaped.

16. Method as in claim 14 or 15, **characterized in that** said two segmented foils (32a, 32b) are first made by shearing, at the same time making the base portion (30) from which said foils (32a, 32b) branch off, in opposite directions and on two parallel but distanced directrixes.

17. Method as in claim 16, **characterized in that** during the making of said two segmented foils (32a, 32b) in a single body with said base portion (30), in said base portion (30) a hole (38) is also obtained, to house a light element (46) and/or a light diffuser.

18. Method as in claim 17, **characterized in that** during the making of said hole (38) two tongues (44) are also obtained, on opposite sides of said hole (38).

19. Method as in any claim from 14 to 18, **characterized in that** in the zones of said two segmented foils (32a, 32b) where the V-shape of the M-shape will be formed, and in the free point of the M, corresponding to the contact portion (34), in a specular position, removals are obtained which will form a channel for the light to transit and for positioning.

20. Method as in claim 19, **characterized in that** in correspondence with each removal made in the V of the M, reinforcement edges (39a, 39b) are obtained, able to prevent the flexion of the foils (32a, 32b) in each segment of their V-shape, and at the same time to constitute a container for the stream of light.

21. Method as in any claim from 14 to 20, **characterized in that** a bridge type deformation (49) is made in said base portion (30), the axis of the deformation being orthogonal to the extension of said foils (32a, 32b).

22. Method to assemble a capacitive sensor (10) as in any claim from 5 to 14 on an electronic card (20), comprising the association of the base portion (30) with a first face (21) of said electronic card (20), by inserting tongues (44), made in said base portion (30), into attachment holes (27) of said electronic card (20) and subsequently bending said tongues (44) so as to cooperate with a second face (22) to ensure the clamping of the capacitive sensor (10) with its base portion (30) anchored to the first face (21) of said electronic card (20).

23. Touch type command board for electronic apparatuses comprising at least a capacitive sensor (10) as in any claim from 1 to 13.

24. Electronic apparatus comprising a touch type command board as in claim 23.
